# EUROPEAN PATENT SPECIFICATION

(11) **EP 4 435 785 B1**
(45) Date of publication and mention of the grant of the patent: **25.11.2026**
(21) Application number: 22903433.5
(22) Date of filing: 06.12.2022
(51) Int. Cl.: G11C 7/00, G11C 11/00, G11C 7/10, G06F 13/16, G06F 13/42

(54) **STORAGE MEDIUM, STORAGE ELEMENT, STORAGE MEDIUM CONFIGURATION METHOD AND DATA TRANSMISSION METHOD**
SPEICHERMEDIUM, SPEICHERELEMENT, SPEICHERMEDIUMKONFIGURATIONSVERFAHREN UND DATENÜBERTRAGUNGSVERFAHREN
SUPPORT DE STOCKAGE, ÉLÉMENT DE STOCKAGE, PROCÉDÉ DE CONFIGURATION DE SUPPORT DE STOCKAGE ET PROCÉDÉ DE TRANSMISSION DE DONNÉES

(30) Priority: 08.12.2021 CN 202111491741; 15.02.2022 CN 202210138758
(43) Date of publication of application: 25.09.2024
(73) Proprietor: Huawei Technologies Co., Ltd., Shenzhen, Guangdong 518129 (CN)
(72) Inventor: ZHU, Xiaoming, Shenzhen, Guangdong 518129 (CN)
(74) Representative: Goddar, Heinz J.
(86) International application number: PCT/CN2022/136803
(87) International publication number: WO 2023/104011

(56) References cited:
- WO-A1-2018/119901
- CN-A- 108 156 823
- CN-A- 110 534 438
- CN-A- 111 512 374
- US-A1- 2004 153 914
- US-A1- 2021 090 650
- US-B1- 6 366 975
- US-B1- 6 493 750
- WANG, RONGHUI: "Research on Exploring And Exploiting Parallelism of Large-scale Flash-based Devices", DOCTORAL DISSERTATION, 28 May 2015 (2015-05-28), CN, pages 1 - 115, XP009546517

## Description

### TECHNICAL FIELD

This application relates to the field of data processing technologies, and in particular, to a storage medium, a storage element, a storage medium configuration method, and a data transmission method.

### BACKGROUND

A storage medium includes a medium die (die), and the medium die is for data transmission. The medium die first needs to complete preparation before the data transmission.

The conventional technology provides a storage medium. The storage medium includes discrete medium dies. Based on the storage medium in such a structure, a controller first sends an instruction to the medium dies, and the medium dies perform preparation according to the received instruction. Then, the controller performs polling check on the medium dies. After the controller confirms, through the polling check, that a medium die has completed preparation, the controller performs data transmission with the medium die that has completed the preparation.

However, such a process in which the controller performs polling check on the medium dies not only occupies processing resources, but also increases a delay in a data transmission process. Therefore, performing data transmission through the storage medium provided in the conventional technology results in a large quantity of occupied processing resources and a long delay in the data transmission process.
US 6 493 750 B1 discloses an interface controller for a communications network port that includes support for an efficient client/server protocol for exchanging data between client computers and target mass storage devices. The interface controller includes support to allow a server computer to forward a read or write command from a client computer to a target mass storage device containing the identification of a client computer as the source of the read or write command. Interface controller support also allows a clients computer to receive response to messages elicited by a read and write command transmitted to a server computer directly from a target mass storage device by copying the identification of the mass storage target device into a data structure within the interface controller to which subsequent identifications within subsequent data and status messages received from the target mass storage device are compared. The client/server protocol eliminates redundant data transfers and eliminates storing and forwarding of data by a server computer.
US 2004/153914 A1 discloses a system for isolating a faulty switch or respective storage device from a plurality of switches and respective storage devices in a daisy-chained arrangement. In the daisy-chain arrangement the switches are connected in sequence to permit access to the respective storage devices through the preceding switches in the sequence. All of the switches, except one, are set in a bypass mode where they do not read inputs of the respective storage devices. The one switch is set in a non bypass mode where it reads an input from its associated storage device. A status of the daisy-chain, either up or down, is then determined. If the status is up, the foregoing steps are repeated a number of iterations with a different one of the switches being set in a non bypass mode and the other switches being set in the bypass mode during each iteration, until the status of the daisy-chain is down. The down status indicates that the switch which is set in the non bypass mode or its associated storage device is defective.

### SUMMARY

The invention provides a storage medium of claim 1, and a storage element of claim 6, to resolve problems that a quantity of occupied processing resources is large and a delay in a data transmission process is long because data transmission is performed through a storage medium provided in the conventional technology. Further embodiment are disclosed in the dependent Technical solutions provided in this application are as follows:

According to a first aspect, a storage medium of claim 1 is provided. The storage medium includes at least two medium dies, the at least two medium dies are sequentially connected via a signal lines to form a closed loop, and the at least two medium dies are for data transmission through a bus. A level of the signal line is controlled by the two medium dies connected via the signal lines, and is used by the at least two medium dies to determine a sequence of performing data transmission through the bus.

In this application, the medium die can determine, based on the level of the signal line, the sequence of performing data transmission through the bus. Therefore, after completing preparation, the medium die can autonomously occupy the bus to complete the data transmission without consuming a processing resource to check, in a polling manner, whether the medium die has completed the preparation. This saves processing resources, reduces a data transmission delay, and improves data transmission efficiency. In addition, because the at least two medium dies are sequentially connected to form the closed loop, in this application, priorities of the medium dies do not need to be determined during packaging of the medium dies, but may be adjusted after the packaging is completed.

In some possible implementations, a level of any signal line is a fixed level, or a level of each signal line is a fixed level. When the level of the any signal line is the fixed level, one of two medium dies connected to the signal line has a highest priority. In the at least two medium dies, a priority of a remaining medium die is determined based on the medium die with the highest priority, and the medium dies have different priorities. Alternatively, when the level of each signal line is the fixed level, the medium dies have a same priority. In this application, the priority of the medium die can be adjusted by controlling the level of the signal line.

In some possible implementations, a medium die in the at least two medium dies includes a selector and a register, the selector is configured to select a first end or a second end of the selector, the first end is for configuring a level of a signal line associated with the register to a fixed level, and the second end indicates that the level of the signal line is controlled, based on a data transmission status, by two medium dies connected via the signal line. On the basis of the medium die, the level of the signal line is further controlled through the selector and the register, and a control manner is flexible.

In some possible implementations, one of the two medium dies connected via the signal line includes the selector and the register. This provides a manner of disposing the selector and the register, and is simple in structure and easy in use.

In some possible implementations, the two medium dies connected via the signal lines each include the selector and the register. This provides another manner of disposing the selector and the register, to provide a surplus selector and register for the signal line, and achieve high reliability.

The signal lines include a request signal line and a feedback signal line.

When the level of the signal lines are fixed levels, a level of the request signal line is a first level, and the first level indicates that authorization is not requested; a level of the feedback signal line is a second level, and the second level indicates that authorization is granted; and the authorization indicates that data transmission is allowed to be performed through the bus. Because the first level indicates that the authorization is not requested, and the second level indicates that the authorization is granted, the medium die can be authorized without requesting the authorization, so that the medium die has the highest priority.

According to the first aspect, when the level of the signal lines is controlled, based on the data transmission status, by the two medium dies connected via the signal line, a level of the request signal line is a first level or a third level, the first level indicates that authorization is not requested, and the third level indicates that authorization is requested; a level of the feedback signal line is a second level or a fourth level, the second level indicates that authorization is granted, and the fourth level indicates that the authorization is not granted; and the authorization indicates that data transmission is allowed to be performed through the bus. The medium die autonomously controls the level of the controller based on the data transmission status, to implement negotiation between different medium dies on the sequence of performing data transmission through the bus.

In some possible implementations, the storage medium further includes a state machine, the state machine is configured to record a status of the medium die, the status of the medium die includes an idle state, a ready state, a data transmission state, and a data transmission state of another medium die, and the data transmission state of the another medium die indicates that the another medium die followed by the medium die is performing data transmission. The state machine records the status of each medium die, to help monitor whether the medium die can operate normally in a data transmission process, and therefore avoid impact of an abnormality of the medium die on the data transmission process.

In some possible implementations, the medium die includes a first data pin and a second data pin, the bus includes a first data bus and a second data bus, the first data pin is configured to be connected to the first data bus, the second data pin is configured to be connected to the second data bus, the first data bus is used by the at least two medium dies to send data, and the second data bus is for sending data to the at least two medium dies. In this implementation, different data buses are used in a read process and a write process, to implement read/write separation, and avoid a conflict between the read process and the write process.

According to a second aspect, a storage element of claim 6 is provided. The storage element includes a controller, and further includes the storage medium according to any one of the first aspect or the possible implementations of the first aspect. The controller is connected, via the bus, to the at least two medium dies included in the storage medium.

The controller is configured to send a data transmission instruction to a first medium die in the at least two medium dies, where the first medium die is any medium die in the at least two medium dies.

The first medium die is configured to receive the data transmission instruction sent by the controller.

The first medium die is further configured to transmit data and a data identifier corresponding to the data to the controller through the bus based on the data transmission instruction and a level of the signal line in the storage medium, where the level of the signal line is controlled by the two medium dies connected via the signal line, and is used by the at least two medium dies to determine a sequence of performing data transmission through the bus.

In some possible implementations, a level of a first signal line in the signal lines is a fixed level, and a level of a second signal line other than the first signal line in the signal lines is controlled, based on a data transmission status, by two medium dies connected via the second signal line. The first signal line is between the first medium die and a next medium die of the first medium die, and the data transmission instruction instructs the first medium die to transmit data. The first medium die is configured to complete preparation according to the data transmission instruction. The first medium die is configured to send the data and the data identifier to the controller through the bus when it is detected that the first signal line is at the fixed level and it is determined, by using a level of a third signal line, that the first medium die does not authorize a previous medium die of the first medium die, where the third signal line is a second signal line between the first medium die and the previous medium die, and the authorization indicates that data transmission is allowed to be performed through the bus. In this implementation, the first medium die has a highest priority, and therefore can occupy the bus for data transmission provided that it is determined that the previous medium die is not authorized.

In some possible implementations, the first medium die is further configured to: after the sending is completed, in response to determining, by using the level of the third signal line, that the previous medium die requests authorization, control the level of the third signal line to authorize the previous medium die when it is determined that the first medium die is not performing sending. When the previous medium die requests the authorization, the first medium die may authorize the previous medium die if the first medium die does not need to occupy the bus for data transmission.

In some possible implementations, a level of a first signal line in the signal lines is controlled by the first medium die and a next medium die of the first medium die based on a data transmission status, and a level of a second signal line other than the first signal line in the signal lines is a fixed level. The first signal line is between the first medium die and the next medium die, and the data transmission instruction instructs the first medium die to transmit data. The first medium die is configured to complete preparation according to the data transmission instruction. The first medium die is configured to control the level of the first signal line to request authorization from the next medium die when it is determined, by using a level of a third signal line, that the first medium die does not authorize a previous medium die of the first medium die, where the third signal line is a second signal line located between the first medium die and the previous medium die, and the authorization indicates that the data transmission is allowed to be performed through the bus. The first medium die is configured to transmit the data and the data identifier corresponding to the data to the controller through the bus when it is determined, by using the level of the first signal line, that the next medium die has granted the authorization. In this implementation, the first medium die does not have a highest priority. Therefore, in addition to determining that the previous medium die is not authorized, the first medium die further needs to be authorized by the next medium die with a higher priority, and then can occupy the bus for data transmission.

In some possible implementations, the medium die is further configured to: after the sending is completed, control the level of the first signal line to request the next medium die to cancel the authorization. The first medium die is further configured to determine, by using the level of the first signal line, that the next medium die has canceled the authorization. Because the first medium die has previously requested the authorization, the first medium die further needs to request to cancel the authorization, to release the bus, so that another medium die occupies the bus for data transmission.

In some possible implementations, the first medium die is configured to: before the first medium die completes the sending, and when it is determined, by using the level of the third signal line, that the previous medium die does not request authorization, control the level of the first signal line to request the next medium die to cancel the authorization. If the previous medium die does not request the authorization from the first medium die in a sending process performed by the first medium die, the first medium die directly requests, after completing the sending, to cancel the authorization.

In some possible implementations, the first medium die is further configured to: before the first medium die completes the sending, and when it is determined, by using the level of the third signal line, that the previous medium die requests authorization, control the level of the third signal line to authorize the previous medium die after the sending is completed. If the previous medium die requests the authorization from the first medium die in a sending process performed by the first medium die, after completing the sending, the first medium die temporarily does not request the next medium die to cancel the authorization, but authorizes the previous medium die.

In some possible implementations, the first medium die is further configured to: after it is determined, by using the level of the first signal line, that the next medium die has canceled the authorization, and when it is determined, by using the level of the third signal line, that the previous medium die requests authorization, and the first medium die is not performing sending, control the level of the first signal line to request authorization from the next medium die. The first medium die is further configured to control the level of the third signal line to authorize the previous medium die when it is determined, by using the level of the first signal line, that the next medium die has granted the authorization. If the first medium die determines, after having requested the next medium die to cancel the authorization, that the previous medium die requests the authorization, the first medium die further needs to request the authorization from the next medium die again, to authorize the previous medium die.

In some possible implementations, the bus includes the first data bus and the second data bus. The first medium die is configured to send the data and the data identifier to the controller through the first data bus, and the second data bus is used by the controller to send, to the at least two medium dies, data that needs to be written. This implementation is for read/write separation.

In some possible implementations, a level of each signal line is a fixed level, and the data transmission instruction instructs the first medium die to perform preparation. The first medium die is configured to complete the preparation according to the data transmission instruction when it is detected that the first signal line is at the fixed level and the third signal line is also at the fixed level, where the first signal line is between the first medium die and a next medium die of the first medium die, and the third signal line is between the first medium die and a previous medium die of the first medium die. The first medium die is configured to transmit the data and the data identifier corresponding to the data to the controller through the bus under control of the controller. In this implementation, the medium dies have a same priority, and the medium die needs to complete a data transmission process under the control of the controller. This implementation may be compatible with a communication protocol in the conventional technology.

In some possible implementations, the bus includes the first data bus and the second data bus. The first medium die is configured to send the data and the data identifier corresponding to the data to the controller through a target data bus. The target data bus is the first data bus or the second data bus. The target data bus is further used by the controller to send, to the at least two medium dies, data that needs to be written. This implementation is a read/write combination manner, and may be compatible with a communication protocol in the conventional technology.

In some possible implementations, the medium die in the at least two medium dies includes the selector and the register. The selector has selected the first end of the selector in response to the level of the signal line being the fixed level, where the first end is for configuring a level of the signal line associated with the register to the fixed level. The selector has selected the second end of the selector in response to the level of the signal line being controlled, based on a data transmission status, by the two medium dies connected via the signal line, where the second end indicates that the level of the signal line is controlled, based on the data transmission status, by the two medium dies connected via the signal line.

The signal line includes the request signal line and the feedback signal line. In response to the level of the signal line being controlled, based on the data transmission status, by the two medium dies connected via the signal line, a level of the request signal line is a first level or a third level, the first level indicates that authorization is not requested, and the third level indicates that authorization is requested; a level of the feedback signal line is a second level or a fourth level, the second level indicates that authorization is granted, and the fourth level indicates that authorization is not granted; and the authorization indicates that data transmission is allowed to be performed through the bus.

In some possible implementations, the storage medium includes the state machine, and the state machine is configured to record a status of the first medium die. The status of the first medium die is an idle state before the first medium die completes the preparation and after the first medium die completes the sending of the data and the data identifier. The status of the first medium die is a ready state after the first medium die completes the preparation. The status of the first medium die is a data transmission state when the first medium die sends the data and the data identifier to the controller. After the first medium die authorizes the previous medium die of the first medium die, the status of the first medium die is a data transmission state of another medium die, where the data transmission state of the another medium die indicates that the another medium die followed by the first medium die is performing data transmission.

### BRIEF DESCRIPTION OF DRAWINGS

FIG. 1 is a schematic diagram of a structure of a storage medium according to an embodiment helpful for understanding the invention but not covered by the claims;
FIG. 2 is a schematic diagram of a structure of a storage medium according to an embodiment of this application;
FIG. 3 is a schematic diagram of a structure of a storage medium according to an embodiment of this application;
FIG. 4 is a schematic diagram of a structure of a storage medium according to an embodiment of this application;
FIG. 5 is a schematic diagram of a structure of a storage medium according to an embodiment of this application;
FIG. 6 is a schematic diagram of a structure of a storage medium according to an embodiment of this application;
FIG. 7 is a schematic diagram of a structure of a storage medium according to an embodiment of this application;
FIG. 8 is a schematic diagram of a structure of a storage element according to an embodiment of this application;
FIG. 9 is a schematic diagram of a structure of a storage element according to an embodiment of this application;
FIG. 10 is a flowchart of a storage medium configuration method useful for the understanding of an embodiment of this application; and
FIG. 11 is a flowchart of a data transmission method useful for the understanding of an embodiment of this application.

### DESCRIPTION OF EMBODIMENTS

Terms used in implementations of this application are only used to explain specific embodiments of this application, but the scope of protection is defined by the claims.

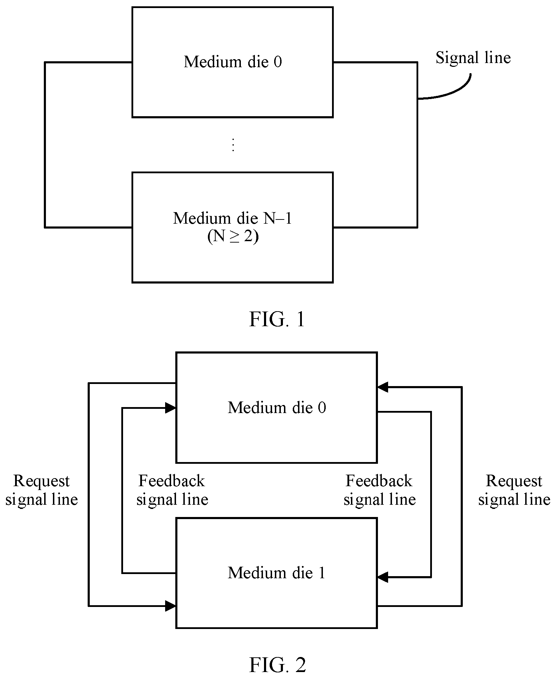

An embodiment of this application provides a storage medium. Refer to FIG. 1. The storage medium includes at least two medium dies. The at least two medium dies are sequentially connected via a signal line to form a closed loop, and the at least two medium dies are for data transmission through a bus. A level of the signal line is controlled by two medium dies connected via the signal line, and is used by the at least two medium dies to determine a sequence of performing data transmission through the bus.

The bus is shared by the at least two medium dies. Different medium dies determine, by using the level of the signal line, the sequence of performing data transmission through the bus, to avoid a conflict that occurs because different medium dies simultaneously occupy the bus for data transmission. For the storage medium provided in this embodiment of this application, after the medium die is instructed by using an instruction to perform preparation, there is no need to consume a processing resource to check, in a polling manner, whether the medium die has completed the preparation. After completing the preparation, the medium die may autonomously determine, by using the level of the signal line, the sequence of performing data transmission through the bus, to occupy the bus to complete data transmission. This saves processing resources, reduces a data transmission delay, and improves data transmission efficiency.

The level of the signal line is for authorization requesting, authorization, authorization cancelation requesting, and authorization cancelation between the two medium dies connected via the signal line, and the authorization indicates that data transmission is allowed to be performed through the bus. For a medium die that has completed preparation, if there is a medium die with a higher priority in the at least two medium dies, when the sequence of performing data transmission through the bus is determined by using the level of the signal line, the medium die that has completed the preparation controls the level of the signal line to request authorization from each medium die with the higher priority. When not needing to occupy the bus, the medium die with the higher priority controls the level of the signal line to authorize the medium die that has completed the preparation, and the medium die that has completed the preparation occupies the bus for data transmission after being authorized. After completing the data transmission, the medium die that has completed the preparation further controls the level of the signal line to request each medium die with the higher priority to cancel the authorization. The medium die with the higher priority controls the level of the signal line to cancel authorizing the medium die that has completed the preparation, to release the bus. Alternatively, if there is no medium die with a higher priority in the at least two medium dies, the medium die that has completed the preparation does not need to request authorization, but directly occupies the bus to complete data transmission. After the data transmission is completed, the bus can be released without a request to cancel the authorization.

It should be noted that, in the conventional technology, when a storage medium includes at least two medium dies, the at least two medium dies are merely sequentially connected via a signal line, but no closed loop is formed. In addition, in the conventional technology, priorities of the medium dies depend on a connection sequence of the medium dies. After the medium dies are packaged (packaged) to obtain the storage medium, the connection sequence of the medium dies remains unchanged. Therefore, the priorities of the medium dies also remain unchanged. Therefore, in the conventional technology, the priorities of the medium dies need to be determined during the packaging of the medium dies, and remain unchanged after the packaging is completed.

However, in this embodiment of this application, the at least two medium dies are sequentially connected via the signal line, and further, the closed loop is formed. After the medium dies are packaged to obtain the storage medium, although a connection sequence of the medium dies remains unchanged, because of a closed-loop structure, when a priority of any medium die changes, a priority of a remaining medium die may also adaptively change, to adjust the priorities of the medium dies. Therefore, in this embodiment of this application, the priorities of the medium dies do not need to be determined during the packaging of the medium dies, but may still be adjusted after the packaging is completed.

In an example embodiment, the level of the signal line includes the following two cases: A1 and A2.

Case A1: A level of any signal line is a fixed level, and a level of a remaining signal line is controlled, based on a data transmission status, by two medium dies connected via the remaining signal line.

It can be learned from the foregoing descriptions that the level of the signal line is for the authorization requesting, the authorization, the authorization cancelation requesting, and the authorization cancelation between the two medium dies connected via the signal line. Therefore, if the level of the any signal line is set to the fixed level, and the fixed level enables one medium die connected to the signal line to be authorized without requesting authorization, it may be determined that the medium die has a highest priority. Because the level of the remaining signal line is controlled, based on the data transmission status, by the two medium dies connected via the remaining signal line, a priority of a remaining medium die may be determined based on the medium die with the highest priority. For example, priorities of other medium dies followed by the medium die with the highest priority sequentially decrease.

Refer to FIG. 2. The signal lines include a request signal line and a feedback signal line. The request signal line is for requesting authorization or requesting to cancel authorization, and the feedback signal line is for authorization or canceling authorization.

In an example embodiment not covert by the claims, when the level of the signal line is the fixed level, a level of the request signal line is a first level, and the first level indicates that authorization is not requested, so that the medium die does not need to request authorization through the request signal line. A level of the feedback signal line is a second level, and the second level indicates that authorization is granted, so that the medium die is directly authorized without requesting authorization.

In the embodiments of the present invention, when the level of the signal line is controlled, based on the data transmission status, by the two medium dies connected via the signal line, a level of the request signal line is a first level or a third level, the first level indicates that authorization is not requested, and the third level indicates that authorization is requested. The medium die controls the level of the request signal line based on an actual data transmission status. When authorization needs to be requested, the level of the request signal line is controlled to be the third level. When authorization cancellation needs to be requested, the level of the request signal line is controlled to be the first level.

A level of the feedback signal line is a second level or a fourth level, the second level indicates that authorization is granted, and the fourth level indicates that authorization is not granted. The medium die controls the level of the request signal line based on an actual data transmission status. When authorization needs to be granted, the level of the request signal line is controlled to be the second level. When authorization needs to be canceled, the level of the request signal line is controlled to be the fourth level.

For example, the first level is the same as the fourth level, the third level is the same as the second level, and the first level is lower than the third level. In this case, the first level and the fourth level are also referred to as low levels, and may be represented by 0. The second level and the third level are also referred to as high levels, and may be represented by 1. In this case, because the request signal line being at the high level (the third level) indicates that the authorization is requested, and the feedback signal line being at the high level (the second level) indicates that the authorization is granted, both the request signal line and the feedback signal line are active-high signal lines.

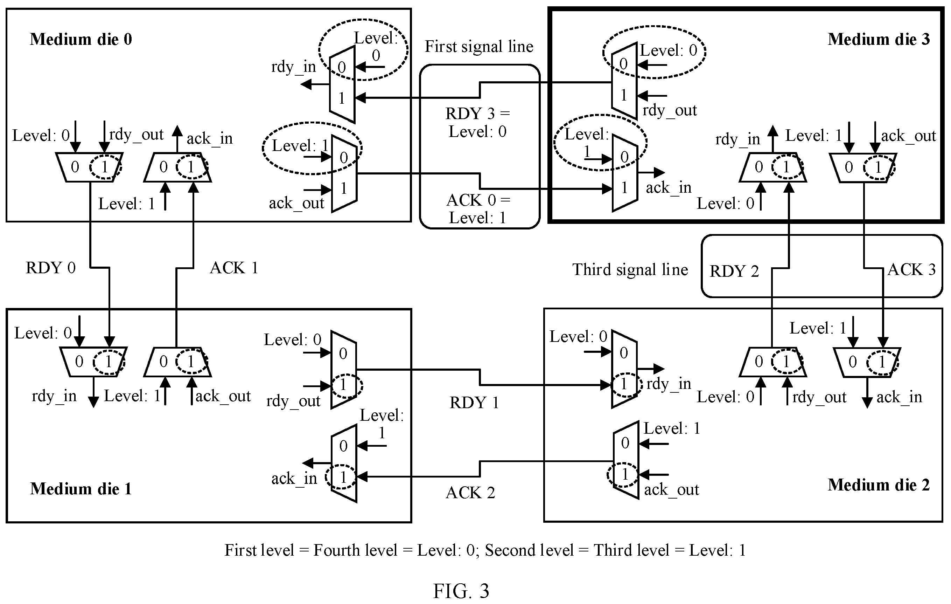

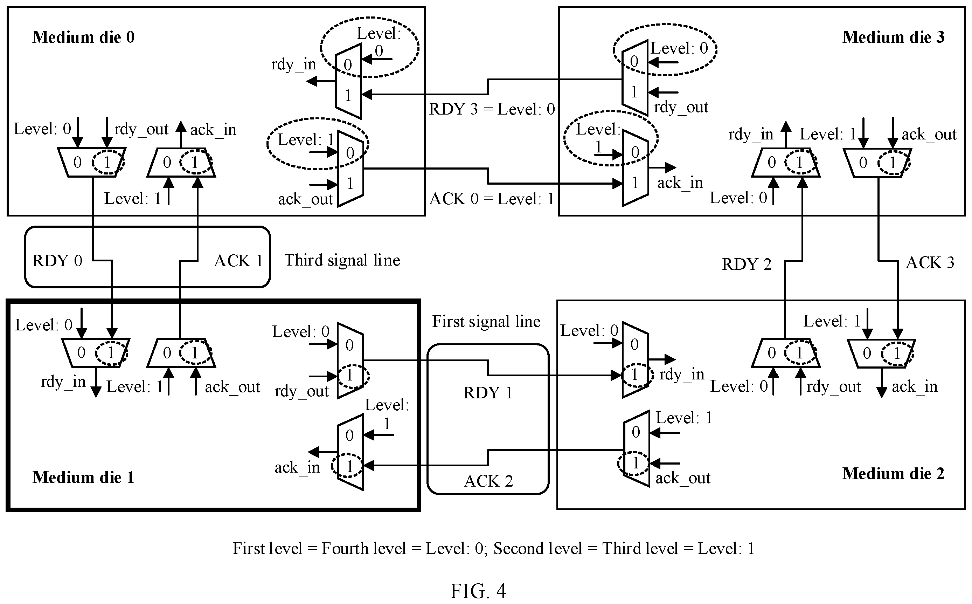

Refer to FIG. 3 and FIG. 4. An example in which a storage medium includes medium dies 0 to 3 is used to describe priorities of the medium dies. A level of RDY 3 is a fixed level, namely, 0, and a level of ACK 0 is a fixed level, namely, 1. Therefore, the medium die 3 can be authorized without requesting authorization from the medium die 0, and has a highest priority. In addition, the medium die 0 and the medium die 1 control levels of RDY 0 and ACK 1 based on a data transmission status. Because RDY 0 is directed from the medium die 0 to the medium die 1, and ACK 1 is directed from the medium die 1 to the medium die 0, between the medium die 0 and the medium die 1, the medium die 0 requests authorization from the medium die 1 or requests the medium die 1 to cancel the authorization, and the medium die 1 authorizes or cancels authorizing the medium die 0. Therefore, a priority of the medium die 0 is lower than that of the medium die 1. Similarly, the medium die 1 and the medium die 2 control levels of RDY 1 and ACK 2 based on a data transmission status, and the priority of the medium die 1 is lower than that of the medium die 2. The medium die 2 and the medium die 3 control levels of RDY 2 and ACK 3 based on a data transmission status, and the priority of the medium die 2 is lower than that of the medium die 3. Therefore, the priorities of the medium die 3, the medium die 2, the medium die 1, and the medium die 0 are in descending order.

Case A2: A level of each signal line is a fixed level.

In the case A2, because the level of each signal line is the fixed level, each medium die is a medium die with a highest priority, and the at least two medium dies have the same priority.

The signal line includes a request signal line and a feedback signal line. When the level of the signal line is the fixed level, for levels of the request signal line and the feedback signal line, refer to the descriptions in the foregoing case A1. Details are not described herein again.

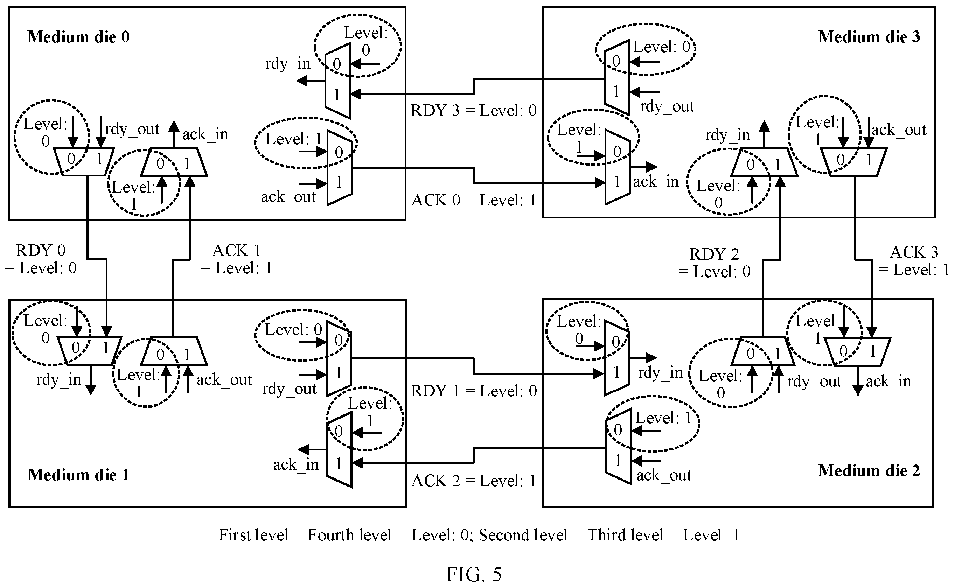

Refer to FIG. 5. An example in which a storage medium includes medium dies 0 to 3 is still used to describe priorities of the medium dies. A level of RDY 3 is a fixed level, namely, 0, and a level of ACK 0 is a fixed level, namely, 1. Therefore, the medium die 3 can be authorized without requesting authorization from the medium die 0, and has a highest priority. In addition, because levels of RDY 0, RDY 1, and RDY 2 are also the fixed level, namely, 0, and levels of ACK 1, ACK 2, and ACK 3 are the fixed level, namely, 1, similarly, the medium die 0, the medium die 1, and the medium die 2 also have the highest priority. Therefore, the medium die 3, the medium die 2, the medium die 1, and the medium die 0 have the same priority.

In an example embodiment, a medium die in the at least two medium dies includes a selector and a register, the selector is configured to select a first end or a second end of the selector, the first end is for configuring a level of a signal line associated with the register to a fixed level, and the second end indicates that the level of the signal line is controlled, based on a data transmission status, by two medium dies connected via the signal line. Therefore, the selector is controlled to select the first end or the second end, to cause the level of the signal line to be the fixed level or to be controlled, based on the data transmission status, by the two medium dies connected via the signal line. Because the priority of the medium die is related to the level of the signal line, the priority of the medium die can be flexibly adjusted in this manner.

When the signal line includes the request signal line and the feedback signal line, the two medium dies connected via the signal line not only include a selector and a register that correspond to the request signal line, but also include a selector and a register that correspond to the feedback signal line, to control the request signal line and the feedback signal line.

For example, a level of any signal line is configured by setting a value of the register. When the register is set to different values, the level of the signal line varies. For example, for the request signal line, when the register is set to 1, the level of the request signal line is a third level. When the register is set to 0, the level of the request signal line is a first level. For another example, for the feedback signal line, when the register is set to 1, the level of the request signal line is a second level. When the register is set to 0, the level of the request signal line is a fourth level.

Certainly, the manner of adjusting the level of the signal line through the selector and the register is merely an example in the foregoing descriptions. For example, in embodiments of this application, alternatively, the medium die may not only control the level of the signal line to be a fixed level, but also control the level of the signal line based on a data transmission status.

In an example embodiment, for two medium dies connected via any signal line, the register and the selector are disposed in the following two manners.

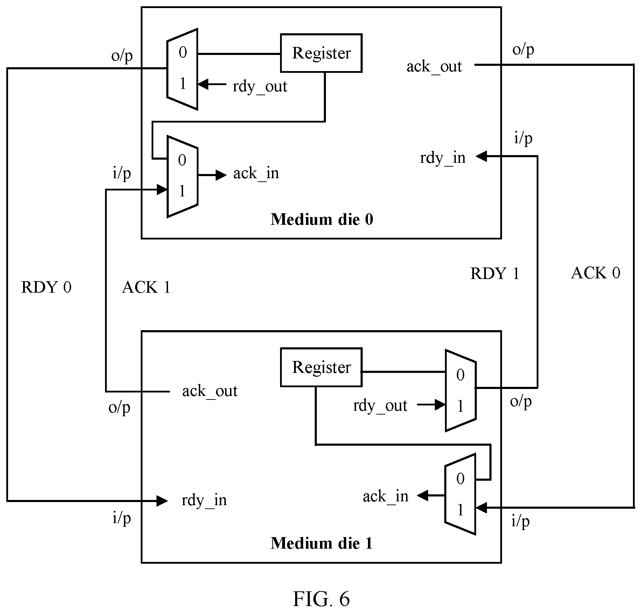

In a first disposition manner, one of the two medium dies connected via the signal line includes the selector and the register. Refer to FIG. 6. For example, when any signal line includes a request signal line and a feedback signal line, one of two medium dies not only includes a selector and a register that correspond to the request signal line, but also includes a selector and a register that correspond to the feedback signal line.

As shown in FIG. 6, the selector is shown as a trapezoid including 0 and 1, where a first end is shown as 0, and a second end is shown as 1. The register is connected to the first end 0 of the selector. A medium die 0 includes a selector and a register that are associated with RDY 0 and ACK 1, and the medium die 1 includes a selector and a register that are associated with RDY 1 and ACK 0. RDY 0 and ACK 1 are used as an example for description, and RDY 1 and ACK 0 are not described herein.

In the medium die 0, if the selector associated with RDY 0 selects the first end 0, a level of RDY 0 is configured by the register; or if the selector associated with RDY 0 selects the second end 1, a level (rdy_out in the medium die 0) of RDY 0 is controlled by the medium die 0 based on a data transmission status, and a level (rdy_in in the medium die 1) that is of RDY 0 and that can be detected by the medium die 1 is the level of RDY 0. In addition, in the medium die 0, if the selector associated with ACK 1 selects the first end 0, a level of ACK 1 is configured by the register; or if the selector associated with ACK 1 selects the second end 1, a level (ack_out in the medium die 1) of ACK 1 is controlled by the medium die 1 based on a data transmission status, and a level (ack_in in the medium die 0) that is of ACK 1 and that can be detected by the medium die 0 is the level of ACK 1.

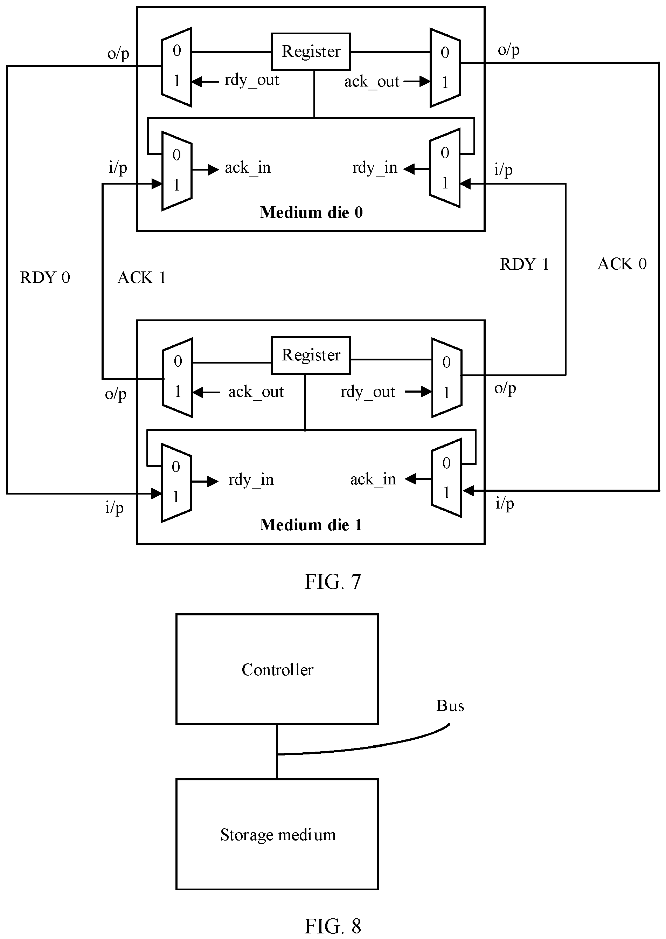

In a second disposition manner, the two medium dies connected via the signal line each include the selector and the register. Refer to FIG. 7. For example, when the signal line includes a request signal line and a feedback signal line, the two medium dies each not only include a selector and a register that correspond to the request signal line, but also include a selector and a register that correspond to the feedback signal line.

As shown in FIG. 7, the selector is shown as a trapezoid including 0 and 1, where a first end is shown as 0, and a second end is shown as 1. The register is connected to the first end 0 of the selector. Both of a medium die 0 and a medium die 1 not only include a selector and a register that are associated with RDY 0 and ACK 1, but also include a selector and a register that are associated with RDY 1 and ACK 0. RDY 0 and ACK 1 are used as an example for description, and RDY 1 and ACK 0 are not described herein.

In the medium die 0 and the medium die 1, if the selectors associated with RDY 0 both select the first end 0, a level of RDY 0 is configured by the register; or if the selectors associated with RDY 0 both select the second end 1, a level (rdy_out in the medium die 0) of RDY 0 is controlled by the medium die 0 based on a data transmission status, and a level (rdy_in in the medium die 1) that is of RDY 0 and that can be detected by the medium die 1 is the level of RDY 0. In addition, in the medium die 0 and the medium die 1, if the selectors associated with ACK 1 both select the first end 0, a level of ACK 1 is configured by the register; or if the selectors associated with ACK 1 both select the second end 1, a level (ack_out in the medium die 1) of ACK 1 is controlled by the medium die 1 based on a data transmission status, and a level (ack_in in the medium die 0) that is of ACK 1 and that can be detected by the medium die 0 is the level of ACK 1.

In addition to the case shown in FIG. 7, there may alternatively be a case in which one of the two medium dies includes a selector and a register that correspond to the request signal line, and the other medium die includes a selector and a register that correspond to the feedback signal line. For another example, there may alternatively be a case in which one of the two medium dies includes a selector and a register that correspond to the request signal line, or includes a selector and a register that correspond to the feedback signal line, and the other medium die not only includes a selector and a register that correspond to the request signal line, but also includes a selector and a register that correspond to the feedback signal line.

For the foregoing two disposition manners, the selector and the register are described herein by using the disposition manner 2 as an example.

Refer to FIG. 3 and FIG. 4. The medium die 3 and the medium die 0 each include a selector and a register that are associated with RDY 3 and ACK 0. The selector associated with RDY 3 and ACK 0 selects a first end (where the first end is shown as 0), so that a register configures the level of RDY 3 to the fixed level, namely, 0, and configures the level of ACK 0 to the fixed level, namely, 1. The medium die 0 and the medium die 1 each include a selector and a register that are associated with RDY 0 and ACK 1, the medium die 1 and the medium die 2 each include a selector and a register that are associated with RDY 1 and ACK 2, and the medium die 2 and the medium die 3 each include a selector and a register that are associated with RDY 2 and ACK 3. The selectors associated with RDY 0, ACK 1, RDY 1, ACK 2, RDY 2, and ACK 3 all select a second end (where the second end is shown as 1). Therefore, the priorities of the medium die 3, the medium die 2, the medium die 1, and the medium die 0 are in descending order.

Refer to FIG. 5. All selectors included in the medium die 3, the medium die 2, the medium die 1, and the medium die 0 select a first end, so that the medium die 3, the medium die 2, the medium die 1, and the medium die 0 have the same priority.

In addition, one medium die may include a plurality of selectors in the foregoing two disposition manners. In some implementations, first ends of the plurality of selectors correspond to a same register. A plurality of bits are arranged on the register, and are in a one-to-one correspondence with the first ends of the plurality of selectors. One bit may configure a level of a signal line associated with the selector corresponding to the bit. In some other implementations, first ends of the plurality of selectors are in a one-to-one correspondence with a plurality of registers. In this case, only one bit needs to be arranged on each register. Details are not described herein.

Because the medium die is for data transmission through the bus, the medium die needs to be connected to the bus. For example, the medium die includes a pin (pin), to be connected to the bus through the pin. In an example embodiment, the medium die includes a first data pin and a second data pin, and the bus includes a first data bus and a second data bus. The first data pin is configured to be connected to the first data bus, and the second data pin is configured to be connected to the second data bus. The first data bus is used by the at least two medium dies to send data, and the second data bus is for sending data to the at least two medium dies.

A process of sending the data by the at least two medium dies is a read (read) process, and the first data bus is also referred to as a read bus. A process of sending the data to the at least two medium dies is a write (write) process, and the second data bus is also referred to as a write bus. Because different data buses are used in the read process and the write process, read/write separation is implemented. A reason for adopting the read/write separation in embodiments of this application is as follows:

In the read process, if the medium die completes preparation and determines, by using the level of the signal line, the sequence of performing data transmission through the bus, the medium die may autonomously occupy the bus for data transmission. Therefore, the read process is a process controlled by the medium die. In the write process, because the medium die needs to receive data sent to the medium die, and then write the data, the write process is a process controlled by a data transmit end (for example, a controller). The read process and the write process are controlled by different objects (the medium die or the data transmit end). Therefore, different data buses need to be used in the read process and the write process, to avoid a conflict between the read process and the write process.

It should be understood that both the first data bus and the second data bus have a function of bidirectional data transmission. In the foregoing embodiment, to implement the read/write separation, the first data bus is merely used by the medium die to send the data, and the second data bus is merely for sending the data to the medium die. For example, the first data bus or the second data bus is used as a target data bus. Based on an actual requirement, the target data bus may alternatively be not only used by the medium die to send data but also for sending data to the medium die. This case implements read/write combination instead of the read/write separation.

For example, the medium die further includes a pin configured to be connected to the signal line, in addition to the pin in the foregoing descriptions. Refer to FIG. 6 and FIG. 7. When the signal line includes the request signal line and the feedback signal line, the pin that is included in the medium die and that is configured to be connected to the signal line is an output pin (output pin, o/p) configured to be connected to the request signal line and an input pin (input pin, i/p) configured to be connected to the feedback signal line.

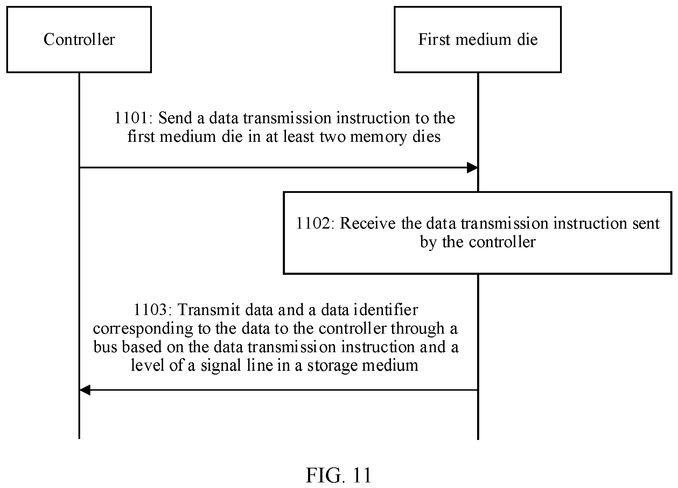

In an example embodiment, the storage medium further includes a state machine. The state machine is configured to record a status of the medium die. The status of the medium die includes an idle state (I), a ready state (R), a data transmission state (T), and a data transmission state (B) of another medium die. The state data transmission state of the another medium die indicates that the another medium die followed by the medium die is performing data transmission. For the states of the medium die, refer to descriptions corresponding to the following data transmission method shown in FIG. 11.

An embodiment of this application further provides a storage element. As shown in FIG. 8, the storage element includes a controller and a storage medium. The controller is connected, via a bus, to at least two medium dies included in the storage medium. The storage medium is the storage medium shown in any one of FIG. 1 to FIG. 7. The bus is for data transmission between the controller and the medium die. A data transmission process includes the foregoing read process and write process. In the read process, the medium die sends data to the controller. In the write process, the controller sends data to the medium die.

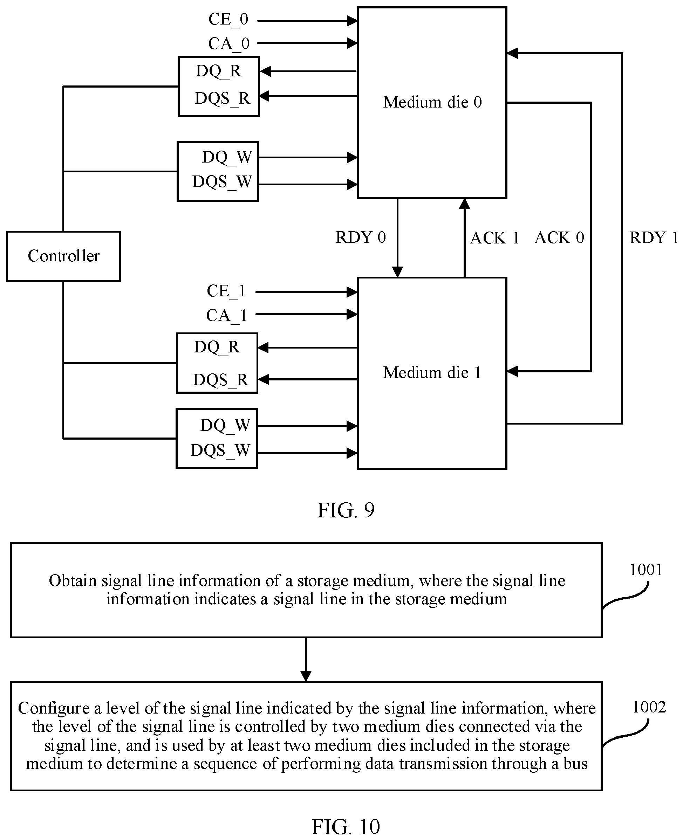

For example, as shown in FIG. 9, the bus includes a first data bus and a second data bus, to implement read/write separation. Still refer to FIG. 9. The first data bus includes DQ_R and DQS_R. DQ_R is used by the medium die to send data to the controller, and DQS_R is used by the medium die to send a clock signal to the controller, so that the controller and the medium die align clock signals in the read process. The second data bus includes DQ_W and DQS_W. DQ_W is used by the controller to send data to the medium die, and DQS_W is used by the controller to transmit a clock signal to the medium die, so that the controller and the medium die align clock signals in the write process. The clock signal indicates a clock cycle, and the clock cycle is a minimum time unit for the data transmission between the controller and the medium die.

Still refer to FIG. 9. In addition to the first data bus and the second data bus, a chip enable (chip enable, CE) bus and a chip address (chip address, CA) bus are further included between the controller and the medium die. The CE bus is used by the controller to send an enable signal to the medium die, so that the medium die has a data transmission capability. The CA bus is used by the controller to send a data transmission instruction to the medium die, where the data transmission instruction includes address information and an operation type. The address information indicates a physical address, of data that needs to be transmitted, in the medium die. The operation type indicates an operation that needs to be performed by the medium die. For example, the operation that needs to be performed by the medium die includes read, write, and the like.

The storage element shown in FIG. 8 or FIG. 9 provided in this embodiment of this application may be configured to perform data transmission. For the data transmission method, refer to the following descriptions corresponding to FIG. 11. Details are not described herein.

An embodiment of this application further provides a storage medium configuration method. The method is applied to configure the storage medium shown in any one of FIG. 1 to FIG. 7. It should be noted that the method may be applied to the controller of the storage element shown in FIG. 8 or FIG. 9. Alternatively, the method may be applied to another electronic device that can be connected to the storage medium shown in any one of FIG. 1 to FIG. 7. As shown in FIG. 10, the storage medium configuration method includes the following step 1001 and step 1002.

Step 1001: Obtain signal line information of the storage medium, where the signal line information indicates the signal line in the storage medium.

The signal line information of the storage medium may be generated in a process of packaging the medium dies to obtain the storage medium.

Step 1002: Configure a level of the signal line indicated by the signal line information, where the level of the signal line is controlled by two medium dies connected via the signal line, and is used by the at least two medium dies included in the storage medium to determine a sequence of performing data transmission through a bus.

Priorities of the medium dies may be adjusted by configuring the level of the signal line. For example, in correspondence with the case A1, FIG. 3, and FIG. 4 in the foregoing descriptions, a level of one signal line is a fixed level, and a level of a remaining signal line is controlled, based on a data transmission status, by two medium dies connected via the remaining signal line. For another example, in correspondence with the case A2 and FIG. 5 in the foregoing descriptions, a level of each signal line is a fixed level.

In an example embodiment, the medium die in the at least two medium dies includes the selector and the register. For the selector and the register, refer to the foregoing descriptions. Details are not described herein again. Correspondingly, the configuring a level of the signal line indicated by the signal line information includes: configuring the selector, to enable the selector to select the first end or the second end.

For a signal line, the signal line has a corresponding target medium die. The target medium die includes a selector and a register that are associated with the signal line. Therefore, in embodiments of this application, the target medium die corresponding to the signal line is first determined when the level of the signal line needs to be configured. Then, the selector included in the target die is configured to enable the selector to select the first end or the second end, to configure the level of the signal line.

An embodiment of this application further provides a data transmission method. The method is applied to the storage element shown in FIG. 8 or FIG. 9. As shown in FIG. 11, the method includes the following step 1101 to step 1103.

Step 1101: The controller sends a data transmission instruction to a first medium die in the at least two medium dies, where the first medium die is any medium die in the at least two medium dies.

The controller first sends an enable signal to the first medium die through the CE bus shown in FIG. 9, where the enable signal enables the first medium die. Then, the controller sends the data transmission instruction to the first medium die through the CA bus shown in FIG. 9.

Step 1102: The first medium die receives the data transmission instruction sent by the controller.

Because the controller sends the data transmission instruction to the first medium die, the first medium die correspondingly receives the data transmission instruction.

Step 1103: The first medium die transmits data and a data identifier corresponding to the data to the controller through the bus based on the data transmission instruction and a level of the signal line in the storage medium, where the level of the signal line is controlled by two medium dies connected via the signal line, and is used by the at least two medium dies to determine a sequence of performing data transmission through the bus.

The first medium die transmits the data and the data identifier to the controller through the bus, and the data identifier is used by the controller to determine which medium die in the at least two medium dies transmits the data. For example, the data identifier is an identifier of the first medium die, and the identifier of the first medium die indicates the first medium die. In this case, after receiving the data and the identifier of the first medium die, the controller may determine, based on the identifier of the first medium die, that the data is transmitted by the first medium die in the at least two medium dies.

In an example embodiment, that the first medium die transmits data and a data identifier corresponding to the data to the controller through the bus based on the data transmission instruction and a level of the signal line in the storage medium includes the following three cases B1 to B3:

Case B1: A level of a first signal line in the signal lines is a fixed level, a level of a second signal line other than the first signal line in the signal lines is controlled, based on a data transmission status, by two medium dies connected via the second signal line, the first signal line is between the first medium die and a next medium die of the first medium die, and the data transmission instruction instructs the first medium die to transmit data.

In the case B1, the first medium die is a medium die with a highest priority, and priorities of medium dies followed by the first medium die are in descending order. Refer to FIG. 3. For example, the first medium die is the medium die 3. The priorities of the medium die 3, the medium die 2, the medium die 1, and the medium die 0 are in descending order.

The data transmission instruction instructs the first medium die to send the data and the data identifier to the controller. In this case, that the first medium die transmits data and a data identifier corresponding to the data to the controller through the bus based on the data transmission instruction and a level of the signal line in the storage medium includes: The first medium die completes preparation according to the data transmission instruction. The data and the data identifier are sent to the controller through the bus when it is detected that the first signal line is at the fixed level and it is determined, by using a level of a third signal line, that the first medium die does not authorize a previous medium die of the first medium die, where the third signal line is a second signal line between the first medium die and the previous medium die, and the authorization indicates that data transmission is allowed to be performed through the bus.

The first medium die that has completed the preparation has a data transmission capability. When detecting that the first signal line is at the fixed level, the first medium die determines that there is no need to request authorization from the next medium die, and has been authorized by the next medium die. When the first medium die determines, by using the level of the third signal line, that the first medium die does not authorize the previous medium die, it indicates that none of the medium dies followed by the first medium die is performing data transmission. Therefore, the first medium die may determine that the bus is idle, and therefore can perform data transmission through the bus, to be specific, can send the data and the data identifier to the controller through the bus.

Still refer to FIG. 3. The first medium die is the medium die 3. The first signal line is RDY 3 and ACK 0, and the third signal line is RDY 2 and ACK 3. When detecting that the level of RDY 3 is 0, the level of ACK 0 is 1, and the level of ACK 3 is 0, the medium die 3 determines that the bus is idle, and sends the data and the data identifier to the controller through the bus.

For example, after the first medium die transmits the data and the data identifier corresponding to the data to the controller through the bus, the method further includes: In response to determining, by using the level of the third signal line, that the previous medium die requests authorization, the first medium die controls the level of the third signal line to authorize the previous medium die when determining that the first medium die is not performing sending. Because the first medium die has the highest priority in the case B1, when the previous medium die requests the authorization from the first medium die, the previous medium die may be authorized provided that the first medium die is not performing sending. That the first medium die is not performing sending means that the first medium die is not performing data and a data identifier to the controller through the bus.

In some implementations, after starting sending and before completing the sending, the first medium die determines that the previous medium die requests authorization. In this case, after completing the sending, the first medium die determines that the first medium die is not performing sending, and therefore authorizes the previous medium die after completing the sending. In some other implementations, after starting sending and completing the sending, the first medium die determines that the previous medium die requests authorization. In this case, the first medium die may directly authorize the previous medium die.

Still refer to FIG. 3. The medium die 2 controls the level of RDY 2 to be 1, to request authorization from the medium die 3. When detecting that the level of RDY 2 is 1, the medium die 3 determines that the medium die 2 requests the authorization. In response to not sending data and a data identifier to the controller by the medium die 3 through the bus, the medium die 3 controls the level of ACK 3 to be 1, to authorize the medium die 2.

For example, after the first medium die controls the level of the third signal line to authorize the previous medium die, the method further includes: In response to determining, by using the level of the third signal line, that the previous medium die requests to cancel the authorization, the first medium die controls the level of the third signal line to cancel authorizing the previous medium die.

As shown in FIG. 3, after the medium die 3 authorizes the medium die 2, the medium die 2 may further control the level of RDY 2 to be 0, to request the medium die 3 to cancel the authorization. When detecting that the level of RDY 2 is 0, the medium die 3 determines that the medium die 2 requests to cancel the authorization. Then, the medium die 3 controls the level of ACK 3 to be 0, to request the medium die 2 to cancel the authorization.

Case B2: Alevel of a first signal line in the signal lines is controlled by the first medium die and a next medium die of the first medium die based on a data transmission status, a level of a second signal line other than the first signal line in the signal lines is a fixed level, and the first signal line is between the first medium die and the next medium die.

In the case B2, the first medium die does not have a highest priority. Priorities of medium dies followed by the first medium die are in descending order, and priorities of medium dies following the first medium die are in ascending order. Refer to FIG. 4. For example, the first medium die is the medium die 1. The priorities of the medium die 3, the medium die 2, the medium die 1, and the medium die 0 are in descending order.

The data transmission instruction instructs the first medium die to send the data and the data identifier to the controller. That the first medium die transmits data and a data identifier corresponding to the data to the controller through the bus based on the data transmission instruction and a level of the signal line in the storage medium includes: The first medium die completes preparation according to the data transmission instruction. The first medium die controls the level of the first signal line to request authorization from the next medium die when determining, by using a level of a third signal line, that the first medium die does not authorize a previous medium die of the first medium die, where the third signal line is a second signal line between the first medium die and the previous medium die, and the authorization indicates that data transmission is allowed to be performed through the bus. The first medium die transmits the data and the data identifier corresponding to the data to the controller through the bus when determining, by using the level of the first signal line, that the next medium die has granted the authorization.

The first medium die that has completed the preparation has a data transmission capability. When the first medium die determines, by using the level of the third signal line, that the first medium die does not authorize the previous medium die, it indicates that none of the medium dies followed by the first medium die is performing data transmission. However, because the first medium die does not have the highest priority, the first medium die further needs to request authorization from a medium die with a higher priority. When being authorized by the medium die with the higher priority, the first medium die can determine that the bus is idle, and therefore can perform data transmission through the bus, to be specific, can send the data to the controller through the bus.

Refer to FIG. 4. The first medium die is the medium die 1. The first signal line is RDY 1 and ACK 2, and the third signal line is RDY 0 and ACK 1. When detecting that the level of ACK 1 is 0, the medium die 1 controls the level of RDY 1 to be 1, to request authorization from the medium die 2. If the medium die 2 does not need to occupy the bus, the medium die 2 controls the level of RDY 2 to be 1, to request authorization from the medium die 3 with a highest priority. If the medium die 3 does not need to occupy the bus, the medium die 3 controls the level of ACK 3 to be 1, to authorize the medium die 2. After detecting that the level of ACK 3 is 1, the medium die 2 determines that the medium die 2 is authorized by the medium die 3, to control the level of ACK 2 to be 1, to authorize the medium die 1. After detecting that the level of ACK 2 is 1, the medium die 1 determines that the medium die 1 is authorized by the medium die 2, and determines, with reference to the level of ACK 1 being 0, that the bus is idle. The medium die 1 may send the data and the data identifier to the controller through the bus.

In an example embodiment, after the first medium die transmits the data and the data identifier to the controller through the bus, the method further includes: The first medium die controls the level of the first signal line to request the next medium die to cancel the authorization. The first medium die determines, by using the level of the first signal line, that the next medium die has canceled the authorization. After starting and completing the sending, the first medium die does not need to continue to occupy the bus. Therefore, the first medium die requests the next medium die to cancel the authorization, and determines that the next medium die has canceled the authorization.

Refer to FIG. 4. For example, the medium die 1 controls the level of RDY 1 to be 0, to request the medium die 2 to cancel the authorization. The medium die 2 controls the level of RDY 2 to be 0, to request the medium die 3 with the highest priority to cancel the authorization. The medium die 3 controls the level of ACK 3 to be 0, to cancel authorizing the medium die 2. After detecting that the level of ACK 3 is 0, the medium die 2 determines that the medium die 3 has canceled the authorization, to control the level of ACK 2 to be 0, to cancel authorizing the medium die 1. After detecting that the level of ACK 2 is 0, the medium die 1 determines that the medium die 2 has canceled the authorization, and the bus is released.

In an example embodiment, that the first medium die controls the level of the first signal line to request the next medium die to cancel the authorization includes: Before completing the sending, and when determining, by using the level of the third signal line, that the previous medium die does not request authorization, the first medium die controls the level of the first signal line to request the next medium die to cancel the authorization. Refer to FIG. 4. For example, if the level of RDY 0 always remains at 0 before and after the medium die 1 completes the sending, after completing the sending, the medium die 1 determines that the medium die 0 does not request authorization. Then, the medium die 1 may control the level of RDY 1 to be 0, to request to cancel the authorization.

In an example embodiment, the method further includes: Before completing the sending, and when determining, by using the level of the third signal line, that the previous medium die requests authorization, the first medium die controls the level of the third signal line to authorize the previous medium die after completing the sending. If the previous medium die requests the authorization from the first medium die in a sending process performed by the first medium die, after completing the sending, the first medium die temporarily does not request the next medium die to cancel the authorization, but authorizes the previous medium die. Refer to FIG. 4. For example, after the medium die 1 starts sending and before the medium die 1 completes the sending, the medium die 0 controls the level of RDY 0 to be 1. In this case, after the medium die 1 completes the sending, because it is detected that the level of RDY 0 is 1, the medium die 1 temporarily does not control the level of RDY 1 to be 0, but controls the level of ACK 1 to be 1, to authorize the medium die 0.

In an example embodiment, after the first medium die determines, by using the level of the first signal line, that the next medium die has canceled the authorization, the method further includes: When the first medium die determines, by using the level of the third signal line, that the previous medium die requests authorization, and the first medium die is not performing sending, the first medium die controls the level of the first signal line to request authorization from the next medium die. The first medium die is further configured to control the level of the third signal line to authorize the previous medium die when it is determined, by using the level of the first signal line, that the next medium die has granted the authorization. If the first medium die determines, after having requested the next medium die to cancel the authorization, that the previous medium die requests the authorization, the first medium die further needs to request authorization from the next medium die again, to authorize the previous medium die.

Refer to FIG. 4. For example, after the medium die 1 has requested to cancel the authorization, the levels of RDY 1 and ACK 2 are both 0. In this case, the medium die 0 controls the level of RDY 0 to be 1, to request authorization from the medium die 1. In this case, the medium die 1 needs to set the level of RDY 1 to 1 again, to request authorization from the medium die 2. After it is detected that the level of ACK 2 is 1, it is determined that the medium die 2 has granted the authorization. Then, the medium die 1 further controls the level of ACK 1 to be 1, to authorize the medium die 0.

For example, after the first medium die controls the level of the third signal line to authorize the previous medium die, the method further includes: If the first medium die determines, based on the level of the third signal line, that the previous medium die requests to cancel the authorization, the first medium die controls the level of the first signal line to request the next medium die to cancel the authorization. After it is determined, by using the level of the first signal line, that the next medium die has canceled the authorization, the level of the third signal line is controlled to cancel authorizing the previous medium die. Refer to FIG. 4. For example, the medium die 0 controls the level of RDY 0 to be 0, to request the medium die 1 to cancel the authorization. The medium die 1 controls the level of RDY 1 to be 0, to request the medium die 2 to cancel the authorization, and determines, after detecting that the level of ACK 2 is 0, that the medium die 2 has canceled the authorization. Then, the medium die 1 further controls the level of ACK 1 to be 0, to cancel authorizing the medium die 0.

In an example embodiment, the bus includes the first data bus and the second data bus. For the foregoing case B1 and case B2, that the first medium die transmits data and a data identifier corresponding to the data to the controller through the bus includes: The first medium die sends the data and the data identifier to the controller through the first data bus, where the second data bus is used by the controller to send, to the at least two medium dies, data that needs to be written, to implement read/write separation.

It can be learned from the foregoing descriptions corresponding to FIG. 9 that the clock cycle is the minimum time unit for data transmission. In some implementations, the first medium die sends the data identifier to the controller in an initial clock cycle, and sends the data to the controller in at least one clock cycle that is after the initial clock cycle. In some other implementations, the first medium die alternately sends the data identifier and the data in different clock cycles.

Case B3: A level of each signal line is a fixed level.

In the case B3, the medium dies have a same priority. Refer to FIG. 5. For example, the first medium die may be any one of the medium die 3, the medium die 2, the medium die 1, and the medium die 0.

The data transmission instruction instructs the first medium die to perform preparation. That the first medium die transmits data and a data identifier corresponding to the data to the controller through the bus based on the data transmission instruction and a level of the signal line in the storage medium includes: The first medium die completes the preparation according to the data transmission instruction when detecting that a first signal line is at a fixed level and a third signal line is also at the fixed level, where the first signal line is between the first medium die and a next medium die of the first medium die, and the third signal line is between the first medium die and a previous medium die of the first medium die. The first medium die transmits the data and the data identifier corresponding to the data to the controller through the bus under control of the controller.

When detecting that the first signal line is at the fixed level, the first medium die determines that there is no need to request authorization from the next medium die, and has been authorized by the next medium die. When detecting that the third signal line is at the fixed level, the first medium die determines that the previous medium die does not request authorization, and has authorized the previous medium die. Therefore, the first medium die determines that the medium dies have the equal priority, and authorization or authorization cancelation is not needed between different medium dies. In this case, the first medium die can directly perform preparation. For example, after completing the preparation according to the data transmission instruction, the first medium die may continue to wait for another instruction sent by the controller. The another instruction instructs the first medium die to send the data and the data identifier to the controller.

Refer to FIG. 5. For example, the first medium die is the medium die 2. In this case, the first signal line is RDY 2 and ACK 3, and the third signal line is RDY 1 and ACK 2. After receiving the data transmission instruction, the medium die 2 detects that the level of RDY 2 is 0, the level of ACK 3 is 1, the level of RDY 1 is 0, and the level of ACK 2 is 1. In this case, the medium die 2 performs preparation according to the data transmission instruction. Next, after receiving the another instruction sent by the controller, the medium die 2 can send the data and the data identifier to the controller according to the another instruction.

In the case B3, after receiving the another instruction, the first medium die transmits the data and the data identifier corresponding to the data to the controller through the bus. In the case B3, the first medium die does not autonomously determine, after completing the preparation, data to be transmitted through the bus. Therefore, the first medium die does not autonomously occupy the bus to complete data transmission, but needs to complete the data transmission under the control of the controller. In a communication protocol provided in the conventional technology, a medium die also needs to complete data transmission under control of a controller. Therefore, the case B3 may be compatible with the communication protocol in the conventional technology. The communication protocol in the conventional technology includes but is not limited to a common flash interface (common flash interface, CFI) protocol and the like.

In an example embodiment, the bus includes the first data bus and the second data bus. That the first medium die transmits data and a data identifier corresponding to the data to the controller through the bus includes: The first medium die sends the data and the data identifier corresponding to the data to the controller through a target data bus, where the target data bus is the first data bus or the second data bus, and is further used by the controller to send, to the at least two medium dies, data that needs to be written, to implement read/write combination. For a manner of sending the data and the data identifier to the controller through the target data bus, refer to the manner of sending the data and the data identifier to the controller through the first data bus in the foregoing descriptions. Details are not described herein again.

In addition, in an example embodiment, the storage medium includes the state machine. The state machine is configured to record a status of the first medium die, namely, an idle state, a ready state, a data transmission state, and a data transmission state of another medium die. In the data transmission method shown in FIG. 11, the state machine records the status of the first medium die in the following manner.

The state machine records the status of the first medium die as the idle state before the first medium die completes the preparation and after the first medium die completes the sending of the data and the data identifier. The status of the first medium die is the ready state after the first medium die completes the preparation. The status of the first medium die is the data transmission state when the first medium die sends the data and the data identifier to the controller. After the first medium die authorizes the previous medium die of the first medium die, the status of the first medium die is the data transmission state of the another medium die, to indicate that the another medium die followed by the first medium die is performing data transmission.

In conclusion, in this embodiment of this application, the medium die can determine, based on the level of the signal line, the sequence of performing data transmission through the bus. Therefore, after completing the preparation, the medium die can autonomously occupy the bus to complete the data transmission without consuming a processing resource to check, in a polling manner, whether the medium die has completed the preparation. This saves processing resources, reduces a data transmission delay, and improves data transmission efficiency.

In addition, because the at least two medium dies are sequentially connected to form the closed loop, in this embodiment of this application, the priorities of the medium dies do not need to be determined during the packaging of the medium dies, but may be adjusted after the packaging.

In an optional embodiment, the storage medium may include a read-only storage medium and a random access storage medium. The storage medium may further include a non-volatile random access storage medium. For example, the storage medium may further store information about a device type. The storage medium may be a volatile storage medium or a non-volatile storage medium, or may include both a volatile storage medium and a non-volatile storage medium. The non-volatile storage medium may be a storage scale memory (storage scale memory, SCM), a read-only memory (read-only memory, ROM), a programmable read-only memory (programmable ROM, PROM), an erasable programmable read-only memory (erasable PROM, EPROM), an electrically erasable programmable read-only memory (electrically EPROM, EEPROM), or a flash memory. The volatile storage medium may be a random access memory (random access memory, RAM), and is used as an external cache. By way of example many forms of RAMs may be used, for example, a static random access memory (static RAM, SRAM), a dynamic random access memory (dynamic random access memory, DRAM), a synchronous dynamic random access memory (synchronous DRAM, SDRAM), a double data rate synchronous dynamic random access memory (double data rate SDRAM, DDR SDRAM), an enhanced synchronous dynamic random access memory (enhanced SDRAM, ESDRAM), a synchlink dynamic random access memory (synchlink DRAM, SLDRAM), and a direct rambus random access memory (direct rambus RAM, DR RAM).

All or some of the foregoing embodiments may be implemented by using software, hardware, firmware, or any combination thereof. When the software is used to implement the embodiments, all or some of the foregoing embodiments may be implemented in a form of a computer program product. The computer program product includes one or more computer instructions. When the computer program instruction is loaded and executed on a computer, all or a part of procedures or functions are generated according to this application. The computer may be a general-purpose computer, a special-purpose computer, a computer network, or other programmable apparatuses. The computer instruction may be stored in a computer-readable storage medium, or may be transmitted from a computer-readable storage medium to another computer-readable storage medium. For example, the computer instruction may be transmitted from a website, computer, server, or data center to another website, computer, server, or data center in a wired (for example, a coaxial cable, an optical fiber, or a digital subscriber line) or wireless (for example, infrared, radio, or microwave) manner. The computer-readable storage medium may be any usable medium accessible by a computer, or a data storage device, such as a server or a data center, integrating one or more usable media. The usable medium may be a magnetic medium (for example, a floppy disk, a hard disk, or a magnetic tape), an optical medium (for example, a DVD), a semiconductor medium (for example, a solid-state drive (Solid-State Drive)), or the like.

In this application, the terms such as "first" and "second" are used to distinguish between same items or similar items that have basically same roles and functions. It should be understood that there is no dependency relationship between "first", "second", and "n^{th}" in terms of logic or a time sequence, and a quantity and an execution sequence are not limited. It should also be understood that although the terms such as "first" and "second" are used in the following descriptions to describe various elements, these elements should not be limited by the terms. These terms are merely used to distinguish one element from another element.

It should be further understood that, in embodiments of this application, sequence numbers of processes do not mean execution sequences. The execution sequences of the processes should be determined according to functions and internal logic of the processes, and should not be construed as any limitation on implementation processes of the embodiments of this application.

In this application, the term "at least one" means one or more. In this application, the term "a plurality of" means two or more. For example, "a plurality of second devices" means "two or more second devices". The terms "system" and "network" usually may be used interchangeably in this specification.

It should be understood that the terms used in the descriptions of various examples in this specification are merely intended to describe specific examples. For example, "a ("a" and "an")" and "the" of singular forms used in the descriptions of various examples and the appended claims are also intended to include plural forms, unless otherwise specified in the context clearly.

It should be further understood that the term "if" may be interpreted as a meaning "when" ("when" or "upon"), "in response to determining", or "in response to detecting". Similarly, according to the context, the phrase "if it is determined that" or "if (a stated condition or event) is detected" may be interpreted as a meaning of "when it is determined that", "in response to determining", "when (a stated condition or event) is detected", or "in response to detecting (a stated condition or event)".

The foregoing descriptions are merely embodiments of this application, but are not intended to limit this application.

## Claims

1. A storage medium, wherein the storage medium comprises at least two medium dies (0-3), the at least two medium dies (0-3) are sequentially connected via signal lines comprising a request signal line and a feedback signal line to form closed loops, and the at least two medium dies (0-3) are for data transmission through a bus; and
a level of the signal lines is controlled by the two medium dies (0-3), and is used by the at least two medium dies (0-3) to determine a sequence of performing data transmission through the bus,
wherein when the levels of the signal lines are controlled, based on the data transmission status, by the at least two medium dies (0-3) connected via the signal lines,
a level of the request signal line is a first level or a third level, the first level indicates that authorization is not requested, and the third level indicates that authorization is requested; a level of the feedback signal line is a second level or a fourth level, the second level indicates that authorization is granted, and the fourth level indicates that authorization is not granted; and the authorization indicates that data transmission is allowed to be performed through the bus.

2. The storage medium according to claim 1, wherein a level of any signal line is a fixed level.

3. The storage medium according to claim 1 or 2, wherein a medium die in the at least two medium dies (0-3) comprises a selector and a register, the selector is configured to select a first end (0) or a second end (1) of the selector, the first end (0) is for configuring a level of a signal line associated with the register to a fixed level, and the second end (1) indicates that the level of the signal line is controlled, based on a data transmission status, by the two medium dies (0-3).

4. The storage medium according to claim 3, wherein one of the two medium dies (0-3) comprises the selector and the register.

5. The storage medium according to claim 4, wherein the two medium dies (0-3) each comprise the selector and the register.

6. A storage element, wherein the storage element comprises a controller and the storage medium according to any one of claims 1 to 5, and the controller is connected, via the bus, to the at least two medium dies (0-3) comprised in the storage medium;
the controller is configured to send a data transmission instruction to a first medium die in the at least two medium dies (0-3), wherein the first medium die is any medium die in the at least two medium dies (0-3);
the first medium die is configured to receive the data transmission instruction sent by the controller; and
the first medium die is further configured to transmit data and a data identifier corresponding to the data to the controller through the bus based on the data transmission instruction and a level of the signal line in the storage medium,.

7. The storage element according to claim 6, wherein a level of a first signal line in the signal lines is a fixed level, a level of a second signal line other than the first signal line in the signal lines is controlled, based on a data transmission status, by two medium dies (0-3) connected via the second signal line, the first signal line is between the first medium die and a next medium die of the first medium die, and the data transmission instruction instructs the first medium die to transmit data;
the first medium die is configured to complete preparation according to the data transmission instruction; and
the first medium die is configured to send the data and the data identifier to the controller through the bus when it is detected that the first signal line is at the fixed level and it is determined, by using a level of a third signal line, that the first medium die does not authorize a previous medium die of the first medium die, wherein the third signal line is a second signal line between the first medium die and the previous medium die, and the authorization indicates that data transmission is allowed to be performed through the bus.

8. The storage element according to claim 7, wherein the first medium die is further configured to: after the sending is completed, in response to determining, by using the level of the third signal line, that the previous medium die requests authorization, control the level of the third signal line to authorize the previous medium die when it is determined that the first medium die is not performing sending.

9. The storage element according to claim 6, wherein a level of a first signal line in the signal lines is controlled by the first medium die and a next medium die of the first medium die based on a data transmission status, a level of a second signal line other than the first signal line in the signal lines is a fixed level, the first signal line is between the first medium die and the next medium die, and the data transmission instruction instructs the first medium die to transmit data;
the first medium die is configured to complete preparation according to the data transmission instruction;
the first medium die is configured to control the level of the first signal line to request authorization from the next medium die when it is determined, by using a level of a third signal line, that the first medium die does not authorize a previous medium die of the first medium die, wherein the third signal line is a second signal line between the first medium die and the previous medium die, and the authorization indicates that data transmission is allowed to be performed through the bus; and
the first medium die is configured to transmit the data and the data identifier corresponding to the data to the controller through the bus when it is determined, by using the level of the first signal line, that the next medium die has granted the authorization.

10. The storage element according to claim 9, wherein the first medium die is further configured to: after the sending is completed, control the level of the first signal line to request the next medium die to cancel the authorization; and
the first medium die is further configured to determine, by using the level of the first signal line, that the next medium die has canceled the authorization.

11. The storage element according to claim 10, wherein the first medium die is configured to: before the first medium die completes the sending, and when it is determined, by using the level of the third signal line, that the previous medium die does not request authorization, control the level of the first signal line to request the next medium die to cancel the authorization.

12. The storage element according to claim 11, wherein the first medium die is further configured to: before the first medium die completes the sending, and when it is determined, by using the level of the third signal line, that the previous medium die requests authorization, control the level of the third signal line to authorize the previous medium die after the sending is completed.

## Patentansprüche

1. Speichermedium, wobei das Speichermedium mindestens zwei Medium-Dies (0-3) umfasst, die mindestens zwei Medium-Dies (0-3) über Signalleitungen, die eine Anforderungssignalleitung und eine Rückkopplungssignalleitung umfassen, sequenziell verbunden sind, um geschlossene Schleifen auszubilden, und die mindestens zwei Medium-Dies (0-3) für eine Datenübertragung mittels eines Busses dienen; und
ein Pegel der Signalleitungen durch die zwei Medium-Dies (0-3) gesteuert wird und durch die mindestens zwei Medium-Dies (0-3) verwendet wird, um eine Sequenz zum Durchführen der Datenübertragung mittels des Busses zu bestimmen, wobei, wenn die Pegel der Signalleitungen basierend auf dem Datenübertragungsstatus durch die mindestens zwei Medium-Dies (0-3), die über die Signalleitungen verbunden sind, gesteuert werden,
ein Pegel der Anforderungssignalleitung ein erster Pegel oder ein dritter Pegel ist, wobei der erste Pegel angibt, dass eine Autorisierung nicht angefordert wird, und der dritte Pegel angibt, dass die Autorisierung angefordert wird; ein Pegel der Rückkopplungssignalleitung ein zweiter Pegel oder ein vierter Pegel ist, wobei der zweite Pegel angibt, dass die Autorisierung erteilt wird, und der vierte Pegel angibt, dass die Autorisierung nicht erteilt wird; und die Autorisierung angibt, dass die Datenübertragung mittels des Busses durchgeführt werden darf.

2. Speichermedium nach Anspruch 1, wobei ein Pegel einer beliebigen Signalleitung ein fester Pegel ist.

3. Speichermedium nach Anspruch 1 oder 2, wobei ein Medium-Die in den mindestens zwei Medium-Dies (0-3) einen Selektor und ein Register umfasst, wobei der Selektor konfiguriert ist, um ein erstes Ende (0) oder ein zweites Ende (1) des Selektors zu selektieren, wobei das erste Ende (0) zum Konfigurieren eines Pegels einer Signalleitung, die dem Register zugeordnet ist, auf einen festen Pegel dient, und das zweite Ende (1) angibt, dass der Pegel der Signalleitung basierend auf einem Datenübertragungsstatus durch die zwei Medium-Dies (0-3) gesteuert wird.

4. Speichermedium nach Anspruch 3, wobei einer der zwei Medium-Dies (0-3) den Selektor und das Register umfasst.

5. Speichermedium nach Anspruch 4, wobei die zwei Medium-Dies (0-3) jeweils den Selektor und das Register umfassen.

6. Speicherelement, wobei das Speicherelement eine Steuerung und das Speichermedium nach einem der Ansprüche 1 bis 5 umfasst, und die Steuerung über den Bus mit den mindestens zwei Medium-Dies (0-3), die in dem Speichermedium umfasst sind, verbunden ist;
die Steuerung konfiguriert ist, um eine Datenübertragungsanweisung an einen ersten Medium-Die in den mindestens zwei Medium-Dies (0-3) zu senden, wobei der erste Medium-Die ein beliebiger Medium-Die in den mindestens zwei Medium-Dies (0-3) ist; der erste Medium-Die konfiguriert ist, um die Datenübertragungsanweisung, die durch die Steuerung gesendet wird, zu empfangen; und
der erste Medium-Die ferner konfiguriert ist, um basierend auf der Datenübertragungsanweisung und einem Pegel der Signalleitung in dem Speichermedium Daten und eine den Daten entsprechende Datenkennung mittels des Busses an die Steuerung zu übertragen,.

7. Speicherelement nach Anspruch 6, wobei ein Pegel einer ersten Signalleitung in den Signalleitungen ein fester Pegel ist, ein Pegel einer zweiten Signalleitung außer der ersten Signalleitung in den Signalleitungen basierend auf einem Datenübertragungsstatus durch zwei Medium-Dies (0-3), die über die zweite Signalleitung verbunden sind, gesteuert wird, die erste Signalleitung zwischen dem ersten Medium-Die und einem nächsten Medium-Die des ersten Medium-Dies liegt, und die Datenübertragungsanweisung den ersten Medium-Die anweist, Daten zu übertragen;
der erste Medium-Die konfiguriert ist, um eine Vorbereitung gemäß der Datenübertragungsanweisung abzuschließen; und
der erste Medium-Die konfiguriert ist, um die Daten und die Datenkennung mittels des Busses an die Steuerung zu senden, wenn erfasst wird, dass sich die erste Signalleitung auf dem festen Pegel befindet, und durch Verwenden eines Pegels einer dritten Signalleitung bestimmt wird, dass der erste Medium-Die einen vorherigen Medium-Die des ersten Medium-Dies nicht autorisiert, wobei die dritte Signalleitung eine zweite Signalleitung zwischen dem ersten Medium-Die und dem vorherigen Medium-Die ist, und die Autorisierung angibt, dass die Datenübertragung mittels des Busses durchgeführt werden darf.

8. Speicherelement nach Anspruch 7, wobei der erste Medium-Die ferner konfiguriert ist zum: nachdem das Senden abgeschlossen ist, als Reaktion auf ein Bestimmen, durch Verwenden des Pegels der dritten Signalleitung, dass der vorherige Medium-Die die Autorisierung anfordert, Steuern des Pegels der dritten Signalleitung, um den vorherigen Medium-Die zu autorisieren, wenn bestimmt wird, dass der erste Medium-Die das Senden nicht durchführt.

9. Speicherelement nach Anspruch 6, wobei ein Pegel einer ersten Signalleitung in den Signalleitungen durch den ersten Medium-Die und einen nächsten Medium-Die des ersten Medium-Dies basierend auf einem Datenübertragungsstatus gesteuert wird, ein Pegel einer zweiten Signalleitung außer der ersten Signalleitung in den Signalleitungen ein fester Pegel ist, die erste Signalleitung zwischen dem ersten Medium-Die und dem nächsten Medium-Die liegt, und die Datenübertragungsanweisung den ersten Medium-Die anweist, Daten zu übertragen; der erste Medium-Die konfiguriert ist, um die Vorbereitung gemäß der Datenübertragungsanweisung abzuschließen;
der erste Medium-Die konfiguriert ist, um den Pegel der ersten Signalleitung zu steuern, um die Autorisierung von dem nächsten Medium-Die anzufordern, wenn durch Verwenden eines Pegels einer dritten Signalleitung bestimmt wird, dass der erste Medium-Die einen vorherigen Medium-Die des ersten Medium-Dies nicht autorisiert, wobei die dritte Signalleitung eine zweite Signalleitung zwischen dem ersten Medium-Die und dem vorherigen Medium-Die ist, und die Autorisierung angibt, dass die Datenübertragung mittels des Busses durchgeführt werden darf; und
der erste Medium-Die konfiguriert ist, um die Daten und die den Daten entsprechende Datenkennung mittels des Busses an die Steuerung zu übertragen, wenn durch Verwenden des Pegels der ersten Signalleitung bestimmt wird, dass der nächste Medium-Die die Autorisierung erteilt hat.

10. Speicherelement nach Anspruch 9, wobei der erste Medium-Die ferner konfiguriert ist zum: nachdem das Senden abgeschlossen ist, Steuern des Pegels der ersten Signalleitung, um anzufordern, dass der nächste Medium-Die die Autorisierung aufhebt; und
der erste Medium-Die ferner konfiguriert ist, um durch Verwenden des Pegels der ersten Signalleitung zu bestimmen, dass der nächste Medium-Die die Autorisierung aufgehoben hat.

11. Speicherelement nach Anspruch 10, wobei der erste Medium-Die konfiguriert ist zum: bevor der erste Medium-Die das Senden abschließt, und wenn durch Verwenden des Pegels der dritten Signalleitung bestimmt wird, dass der vorherige Medium-Die die Autorisierung nicht anfordert, Steuern des Pegels der ersten Signalleitung, um anzufordern, dass der nächste Medium-Die die Autorisierung aufhebt.

12. Speicherelement nach Anspruch 11, wobei der erste Medium-Die ferner konfiguriert ist zum: bevor der erste Medium-Die das Senden abschließt, und wenn durch Verwenden des Pegels der dritten Signalleitung bestimmt wird, dass der vorherige Medium-Die die Autorisierung anfordert, Steuern des Pegels der dritten Signalleitung, um den vorherigen Medium-Die zu autorisieren, nachdem das Senden abgeschlossen ist.

## Revendications

1. Support de stockage, dans lequel le support de stockage comprend au moins deux puces de support (0 à 3), les au moins deux puces de support (0 à 3) sont connectées de manière séquentielle par le biais de lignes de signal comprenant une ligne de signal de demande et une ligne de signal de retour pour former des boucles fermées, et les au moins deux puces de support (0 à 3) sont destinées à une transmission de données par le biais d'un bus ; et
un niveau des lignes de signal est commandé par les deux puces de support (0 à 3) et est utilisé par les au moins deux puces de support (0 à 3) pour déterminer une séquence de réalisation de transmission de données par le biais du bus,
dans lequel, lorsque les niveaux des lignes de signal sont commandés, sur la base de l'état de transmission de données, par les au moins deux puces de support (0 à 3) connectées par l'intermédiaire des lignes de signal,
un niveau de la ligne de signal de demande est un premier niveau ou un troisième niveau, le premier niveau indique qu'une autorisation n'est pas demandée, et le troisième niveau indique qu'une autorisation est demandée ; un niveau de la ligne de signal de retour est un deuxième niveau ou un quatrième niveau, le deuxième niveau indique qu'une autorisation est accordée, et le quatrième niveau indique qu'une autorisation n'est pas accordée ; et l'autorisation indique qu'une transmission de données est autorisée à être réalisée par le biais du bus.

2. Support de stockage selon la revendication 1, dans lequel un niveau d'une quelconque ligne de signal est un niveau fixe.

3. Support de stockage selon la revendication 1 ou 2, dans lequel une puce de support parmi les au moins deux puces de support (0 à 3) comprend un sélecteur et un registre, le sélecteur est configuré pour sélectionner une première extrémité (0) ou une seconde extrémité (1) du sélecteur, la première extrémité (0) est destinée à configurer un niveau d'une ligne de signal associée au registre à un niveau fixe, et la seconde extrémité (1) indique que le niveau de la ligne de signal est commandé, sur la base d'un état de transmission de données, par les deux puces de support (0 à 3).

4. Support de stockage selon la revendication 3, dans lequel l'une parmi les deux puces de support (0 à 3) comprend le sélecteur et le registre.

5. Support de stockage selon la revendication 4, dans lequel les deux puces de support (0 à 3) comprennent chacune le sélecteur et le registre.

6. Élément de stockage, dans lequel l'élément de stockage comprend un dispositif de commande et le support de stockage selon l'une quelconque des revendications 1 à 5, et le dispositif de commande est connecté, par l'intermédiaire du bus, aux au moins deux puces de support (0 à 3) comprises dans le support de stockage ;
le dispositif de commande est configuré pour envoyer une instruction de transmission de données à une première puce de support parmi les au moins deux puces de support (0 à 3), dans lequel la première puce de support est une quelconque puce de support parmi les au moins deux puces de support (0 à 3) ;
la première puce de support est configurée pour recevoir l'instruction de transmission de données envoyée par le dispositif de commande ; et
la première puce de support est en outre configurée pour transmettre des données et un identifiant de données correspondant aux données au dispositif de commande par le biais du bus sur la base de l'instruction de transmission de données et d'un niveau de la ligne de signal dans le support de stockage.

7. Élément de stockage selon la revendication 6, dans lequel un niveau d'une première ligne de signal parmi les lignes de signal est un niveau fixe, un niveau d'une deuxième ligne de signal autre que la première ligne de signal parmi les lignes de signal est commandé, sur la base d'un état de transmission de données, par deux puces de support (0 à 3) connectées par l'intermédiaire de la deuxième ligne de signal, la première ligne de signal est entre la première puce de support et une puce de support suivante de la première puce de support, et l'instruction de transmission de données ordonne à la première puce de support de transmettre des données ;
la première puce de support est configurée pour terminer une préparation selon l'instruction de transmission de données ; et
la première puce de support est configurée pour envoyer les données et l'identifiant de données au dispositif de commande par le biais du bus lorsqu'il est détecté que la première ligne de signal est au niveau fixe et qu'il est déterminé, en utilisant un niveau d'une troisième ligne de signal, que la première puce de support n'autorise pas une puce de support précédente de la première puce de support, dans lequel la troisième ligne de signal est une deuxième ligne de signal entre la première puce de support et la puce de support précédente, et l'autorisation indique qu'une transmission de données est autorisée à être réalisée par le biais du bus.

8. Élément de stockage selon la revendication 7, dans lequel la première puce de support est en outre configurée pour : une fois l'envoi terminé, en réponse au fait de déterminer, en utilisant le niveau de la troisième ligne de signal, que la puce de support précédente demande une autorisation, commander le niveau de la troisième ligne de signal pour autoriser la puce de support précédente lorsqu'il est déterminé que la première puce de support ne réalise pas d'envoi.

9. Élément de stockage selon la revendication 6, dans lequel un niveau d'une première ligne de signal parmi les lignes de signal est commandé par la première puce de support et une puce de support suivante de la première puce de support sur la base d'un état de transmission de données, un niveau d'une deuxième ligne de signal autre que la première ligne de signal parmi les lignes de signal est un niveau fixe, la première ligne de signal est entre la première puce de support et la puce de support suivante, et l'instruction de transmission de données ordonne à la première puce de support de transmettre des données ;
la première puce de support est configurée pour terminer une préparation selon l'instruction de transmission de données ;
la première puce de support est configurée pour commander le niveau de la première ligne de signal afin de demander une autorisation à la puce de support suivante lorsqu'il est déterminé, en utilisant un niveau d'une troisième ligne de signal, que la première puce de support n'autorise pas une puce de support précédente de la première puce de support, dans lequel la troisième ligne de signal est une deuxième ligne de signal entre la première puce de support et la puce de support précédente, et l'autorisation indique qu'une transmission de données est autorisée à être réalisée par le biais du bus ; et
la première puce de support est configurée pour transmettre les données et l'identifiant de données correspondant aux données au dispositif de commande par le biais du bus lorsqu'il est déterminé, en utilisant le niveau de la première ligne de signal, que la puce de support suivante a accordé l'autorisation.

10. Élément de stockage selon la revendication 9, dans lequel la première puce de support est en outre configurée pour : une fois l'envoi terminé, commander le niveau de la première ligne de signal pour demander à la puce de support suivante d'annuler l'autorisation ; et
la première puce de support est en outre configurée pour déterminer, en utilisant le niveau de la première ligne de signal, que la puce de support suivante a annulé l'autorisation.

11. Élément de stockage selon la revendication 10, dans lequel la première puce de support est configurée pour : avant que la première puce de support ne termine l'envoi, et lorsqu'il est déterminé, en utilisant le niveau de la troisième ligne de signal, que la puce de support précédente ne demande pas d'autorisation, commander le niveau de la première ligne de signal pour demander à la puce de support suivante d'annuler l'autorisation.

12. Élément de stockage selon la revendication 11, dans lequel la première puce de support est en outre configurée pour : avant que la première puce de support ne termine l'envoi, et lorsqu'il est déterminé, en utilisant le niveau de la troisième ligne de signal, que la puce de support précédente demande une autorisation, commander le niveau de la troisième ligne de signal pour autoriser la puce de support précédente une fois l'envoi terminé.
